# EUROPEAN PATENT APPLICATION

(11) **EP 0 606 667 A1**
(43) Date of publication of application: **20.07.1994**
(21) Application number: 93200076.3
(22) Date of filing: 13.01.1993
(51) Int. Cl.: H01L 27/02

(54) **Semiconductor device with an integrated circuit provided with over voltage protection means**

(71) Applicant: Philips Electronics N.V., 5621 BA Eindhoven (NL); FASELEC A.G., CH-8045 Zürich (CH)
(72) Inventor: Gloor, Daniel, NL-5656 AA Eindhoven (NL)
(74) Representative: Veerman, Jan Willem

(57) **Abstract**

The present invention relates to an integrated circuit comprising a plurality of information terminals (3) for transferring information between a number of circuit components (T1,T2) and an external environment, which are provided with over voltage protection means (D1,D2,D3). Said circuit components (T1,T2) are coupled between a first supply terminal (1) and a second supply terminal (2).

The protection means comprise a first protection device (D1) which is coupled between the first supply terminal (1) and the information terminal (3) as well as a second protection device (D2) which is connected between the information terminal (3) and the second supply terminal (3). The protection means moreover comprise a third protection device (D3) which is connected between the first supply terminal (1) and the second supply terminal (2), and which has a smaller reverse breakdown voltage than the first and second protection device (D1,D2). As the third protection device (D3) is shared in common by the information terminals (3) chip area is saved with such protection means.

## Description

The invention relates to a semiconductor device with an integrated circuit comprising a number of information terminals for transferring information between a number of circuit components and an external environment, in which said circuit components are coupled to a first supply terminal and to a second supply terminal and in which the information terminals are each provided with over voltage protection means, which comprise a first protection device connected between the first supply terminal and the information terminal and a second protection device connected between the information terminal and the second supply terminal.

Said protection means are intended to limit the potential on the information terminal to a save level, thereby protecting the circuit components against permanent damage due to over voltage surges arising on the information terminal. These surges may for instance be a consequence of electrostatic discharge, generally referred to as ESD. ESD is difficult to avoid during IC assembly, test, transfer or other handling. Static electricity, generated by individually touching an IC or by sliding IC's down a rails of a carrier tube or a test device, discharges across an IC. A person readily generates 1000-10000 Volts of static electricity. Although the resistance of the human body partially alleviates the destructive effect of this high voltage, the resulting voltage may nevertheless be very damaging to the IC. The ESD produced when the IC slides down a rails may be equally harmful.

Metal-oxide-semiconductor (MOS) IC's are especially prone to ESD damage because their relatively thin gate dielectrics rupture already at moderate voltages. Though somewhat less than in MOS IC's, ESD is however also a problem to bipolar integrated circuits. In bipolar IC's, the emitter-base junctions are most susceptible to ESD damage. As IC dimensions shrink and the packing density increases, ESD becomes more of a concern for both bipolar and MOS IC's. Consequently protection means are usually incorporated into the IC to prevent ESD damage.

The protection means generally consist of one or more protection devices which may for instance consist of a diode or a transistor- or thyristor structure. These devices have in common that they comprise at least one rectifying junction which is reverse biassed during normal operation but which is capable of providing an additional current path on the occurrence of a voltage surge on the information terminal. The electric charge associated with the voltage surge is fed away safely and quickly through said additional current path, such that the voltage on the information terminal does not reach a destructive level. In this manner the circuit component coupled to the information terminal is prevented from being affected by said voltage surge.

A semiconductor device of the kind described in the opening paragraph is known from US Patent number 3.967.295. This document describes a semiconductor device with a CMOS integrated circuit in which two complementary MOS transistors are connected between a first supply terminal and a second supply terminal. During operation, the first supply terminal is connected to a relatively high potential, designated V_{dd}, and the second supply terminal is kept at a relatively low potential, designated Vₛₛ. The gate electrodes of transistors are connected to a common information terminal. The information terminal is intended to receive information in the form of an electrical signal of the magnitude of either V_{dd} or Vₛₛ.

In the known device, the information terminal is provided with protection means consisting of a first diode connected with its cathode region to the first supply terminal and with its anode region to the information terminal as well as of a second diode connected with its cathode region to the information terminal and with its anode region to the second supply terminal. Under normal operation both diodes are reverse biased to a level below their normal breakdown potential. If however the potential on the information line drops below Vₛₛ the second diode is rendered conducting and delivers a additional current path to the second supply terminal through which the information line may be discharged. If likewise the voltage of the information line exceeds V_{dd} the first diode is forward biassed, providing an additional current path to the first supply terminal in order to limit the voltage on the information line to a safe level. Under severe ESD one of the diodes may be reverse biased to a level beyond its breakdown voltage. In that case a current path is provided by electrical breakdown of said diode, which consequently should be capable of withstanding such reverse breakdown conditions.

The protection means ideally present an infinite resistance during normal operation but on the other hand a short circuit on the occurrence of a potentially harmful voltage surge. The latter means that the protecting means should have an extremely low impedance when conducting the discharge current. To fulfil this condition, particularly also in reverse breakdown mode, the protection means of the known semiconductor device require a relatively large amount of surface area. With a trend in integrated circuits towards ever smaller dimensions and higher packing densities, leading to an increase of the number of circuit components to be protected and moreover to a decrease of the maximum tolerable voltage, the surface area necessarily occupied by the protection means tend to grow and will more and more impose a limitation to a further increase of packing density.

It is therefore an object of the present invention to provide a semiconductor device with over voltage protection means which require only a relatively small amount of surface area.

In accordance with the invention, a semiconductor device as described in the opening paragraph is characterized in that the protection means moreover comprise a third protection device connected between the first supply terminal and the second supply terminal, in that the third protection device has a smaller reverse breakdown voltage than the first- and second protection device, and in that said information terminals share the third protection device in common.

The invention is thereby based on the recognition that with the breakdown voltage of the third protection device selected in relation to the breakdown voltages of the first and second protection device as described above, on the occurrence of a voltage surge on the information terminal, only the third protection device might be stressed in reverse. This will be explained in larger detail below, with reference to some drawings. The other two protection devices are either stressed in forward or not stressed at all.

Because neither the first nor the second protection device are stressed in reverse, these devices need only have a sufficiently small resistance in forward direction. This can be achieved with only a relatively small amount of chip area occupied by these devices.

Only the third protection device requires a sufficient amount of chip area to give it a sufficiently small resistance in reverse mode as well. However as the third protection device is shared in common by the information terminals, on the whole, the area occupied by the third protection device does not much affect the total area necessary to accommodate the entire integrated circuit.

Especially in integrated circuits with a large number of pins and hence with a large number of information terminals and circuit components to be protected, a considerable amount of chip area can be saved if the present invention is incorporated.

In a particular embodiment of the present invention the first and second protection device both comprise a diode whereas the third protection device comprises a bipolar transistor connected with an emitter region and a collector region to the supply terminals. If, on the occurrence of a voltage surge on the information terminal, the collector-base junction of the third protection device is stressed in reverse beyond its breakdown voltage an avalanche current starts to flow which forms a base current for the transistor. As a result the third protection device becomes conducting and provides a current path through which the information terminal may be discharged safely. Said breakdown voltage of the collector-base junction can easily be devised in accordance with the invention such that it is lower than the breakdown voltages of both the first and second protection device.

The foregoing and additional objects, features and advantages of the present invention will become more apparent from the following detailed description of a particular embodiment thereof, taken in conjunction with an accompanying drawing, in which:
- Fig. 1: represents a circuit diagram of a part of an integrated circuit comprising protection means in accordance with the invention;
- Fig. 2: gives a reverse current-voltage of the different protection devices applied in the circuit of figure 1;
- Figs. 3A-3D: represent the circuit of figure 1 under different ESD-circumstances; and
- Figs. 4A-4D: represent a cross-sectional views of a semiconductor device incorporating the circuit of figure 1.
It is noted that the figures are merely schematic and not drawn to scale. In particular some dimensions have been exaggerated strongly for sake of clarity. Corresponding parts are designated by the same reference signs throughout the figures and regions of the same conductivity type are hatched in the same direction in the cross-sectional views.

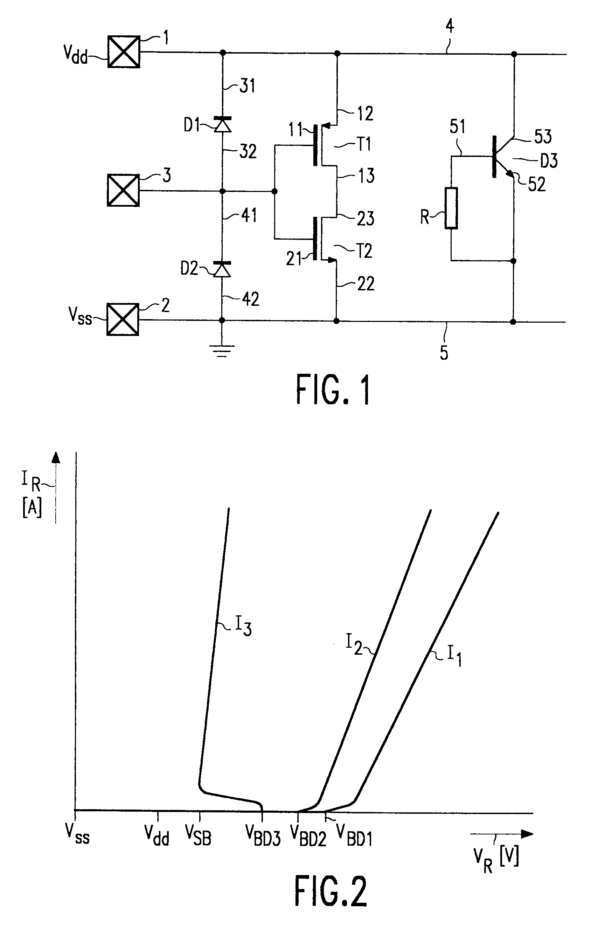

The integrated circuit of the invention comprises several information terminals for transferring information between an external environment and a number of circuit components which are coupled to a first supply line and a second supply line. Figure 1 shows a part of the integrated circuit which is directly associated with one of said information terminals. This part of the circuit comprises two circuit components in the form of complementary metal oxide semiconductor (MOS) transistors T1 and T2, the first one being a p-channel MOS-transistor and the second one T2 a n-channel MOS-transistor. The transistors T1, T2 are connected in a series arrangement between the first supply terminal 1 and the second supply terminal 2, the source electrode 12 of the PMOST T1 being coupled to the first supply terminal 1 via a first supply line 4, the source electrode 22 of the NMOST T2 being coupled to the second supply terminal 2 via a second supply line 5 and the drain electrodes 13,23 of both transistors T1,T2 being mutually interconnected. During operation, the first supply terminal 1 and the second supply terminal 2 receive suitable supply voltages referred to as V_{dd} and Vₛₛ respectively, V_{dd} being larger than Vₛₛ.

The gate electrodes 11,12 of both transistors are mutually interconnected and coupled to a common information terminal 3 via a common information line 6 for transferring information, such as digital data or analog electrical signals, between the transistors T1,T2 and an external environment during operation. In this case the information terminal 3 constitutes an input terminal by which information can be delivered to the transistor circuit T1,T2. At its exterior, the integrated circuit carries an input pin which is connected in a conventional manner to the input terminal 3 for instance by means of a bonding wire attached to a bond pad of the circuit.

The integrated circuit is provided with protection means in order to protect the transistors T1 ,T2 against over voltage surges which may arise on the input terminal 3 and the input line 6 from outside via the input pin. In this particular case, the protection means comprise a first protection device D1 in the form of a first semiconductor diode and a second protection device D2 in the form of a second semiconductor diode connected between the information terminal 3 and one of the supply terminals 1,2 as well as a third protection device D3 in the form of a bipolar NPN transistor connected between the supply terminals 1,2.

The first semiconductor diode D1 comprises a cathode electrode 31 by which it is connected to the first supply line and a cathode electrode 32 which is connected to the information terminal 3. Similarly, the second semiconductor diode D2 is connected with its cathode electrode 41 to the information terminal 3 and with its anode region 42 to the second supply terminal 2. The diodes D1, D2 specifically protect only the transistors T1, T2 connected to the same information terminal 3 against over-voltage surges.

During normal operation, i.e. with the intended supply voltages Vₛₛ and V_{dd} on the supply terminals 1,2 and the information terminal 3 at a voltage in between, both diodes D1,D2 are reverse biassed and non-conducting. If however the voltage over one of the diodes exceeds its reverse breakdown voltage V_{BD1}, V_{BD2} respectively avalanche breakdown will occur and the respective diode will conduct a reverse current I_{R} as indicated by the curves I₁ and I₂ respectively depicted in figure 2. The slope of the associated part of the curves I₁,I₂ corresponds to a reverse resistance of the order of about 30 Ω. The breakdown voltage of the diodes D1,D2 is typically in the range between 20 and 30 Volt.

The bipolar transistor D3 comprises a collector electrode 53 by which it is connected to the first supply terminal 1 and an emitter electrode 52 which is connected to second supply terminal 2 as well as to a base electrode 51 of the transistor D3. The resistor R in the figure resembles the internal base resistance of the transistor.

Connected in this manner in reverse, the transistor D3 is non-conducting during normal operation, i.e. with the intended supply voltages Vₛₛ and V_{dd} on the supply terminals. The relation between the reverse-voltage V_{R} over the device D3 and the current I_{R} through it is given by the curve I₃ drawn schematically in figure 2. If however the potential difference between the first and second supply terminal exceeds the breakdown voltage V_{BD3} of the collector-base junction of the transistor D3, avalanche breakdown occurs and holes are injected into the base 51 forming a base current as a result of which the base potential increases and the emitter-base junction of the transistor may be forward biassed. In this mode, generally referred to as snap-back, the transistor as a whole is rendered conducting and the voltage over the transistor drops to a value V_{SB3} below its break-down voltage V_{BD3}. The breakdown voltage V_{BD3} of the transistor D3 lies typically in the range from 10 to 15 Volt whereas the snap-back voltage V_{SB3} is typically about 8 Volt.

In snap-back mode, the reverse resistance of the transistor D3 is extremely low as may be derived from the corresponding steep part of the curve I₃. The reverse resistance of the transistor D3 is typically about 2 Ω and therewith sufficiently small to withstand a relatively large current.

Under normal operational conditions, i.e. the supply terminals 1,2 fed with the intended supply voltages V_{dd},V_{dd} and the information terminal 3 carrying an information signal, all protection devices D1..D3 are reverse biassed and, apart from an inevitable minor leakage current, non-conducting. As long as this situation exists, the protection devices D1..D3 have no or only little effect on the information transmission. If however a voltage surge, e.g. due to electrostatic discharge (ESD), suddenly causes the voltage on the information terminal to approach a magnitude that could damage the protected MOS-transistors T1,T2 the protection means become active and will attempt to limit the voltage rise to a non-destructive level by discharging the excess charge on the information terminal 3 to a point of fixed potential.

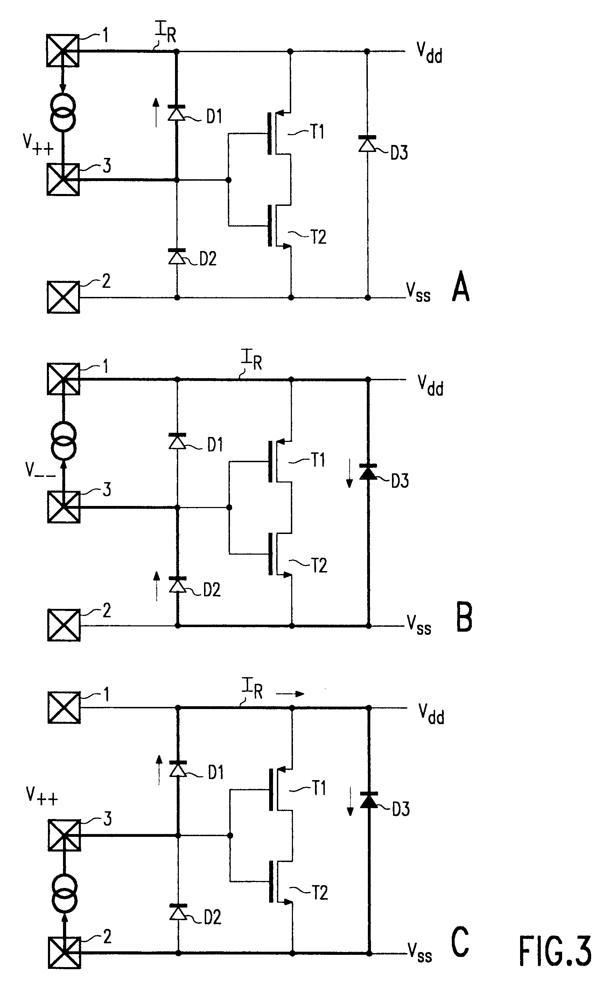

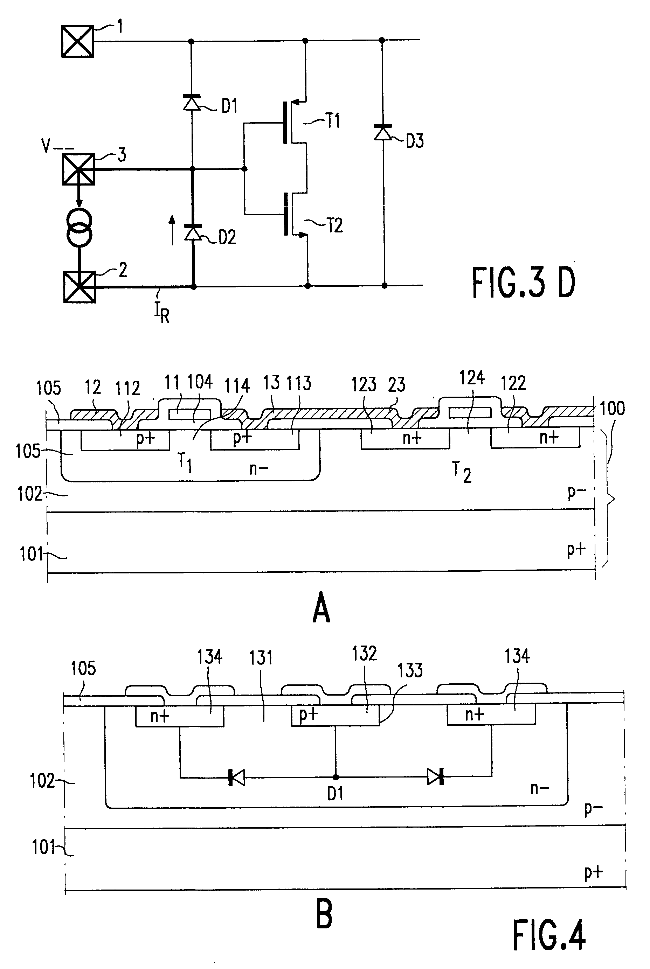

The figures 3A-3D show the flow of this discharge current I_{R} depending on the polarity of the voltage surge V⁺⁺,V⁻⁻, which is positive in figs. 3A and 3C and negative in figs. 3B and 3D, and on whether the excess charge is fed to either the first supply terminal 1, as in case of figs. 3A and 3B, or the second supply terminal 2, as in case of figs. 3C and 3D. For sake of clarity, the third protection device D3 is represented by an ordinary diode and any one of the protection devices D1..D3 is marked black in case it is stressed in reverse.

In order to be able to withstand the discharge current I_{R} the resistance of a protection should be smaller than about 10 Ω. When stressed in forward all three protection devices D1..D3 meet with this requirement, as they all have a resistance of about 1,5 Ω in that case.

In reverse, on the other hand, only the third protection device D3 has a resistance below 10 Ω. However, due to the fact that the breakdown voltage V_{BD3} of the third protection device D3 is selected in accordance with the present invention to be smaller than the breakdown voltages V_{BD1,2} of both other protection devices D1,D2, it is only the third protection device D3 that might be stressed in reverse. The other protection devices D1,D2 are only stressed in forward direction or not stressed at all. As a consequence the protection devices D1,D2 operate satisfactorily despite their reverse resistance beyond the critical value of 10 Ω. This means that, due to the invention, the surface area occupied by the first and second protection device 1,2 does not have to be extended in order to lower their reverse resistance so that valuable chip area is saved for every information terminal of the integrated circuit provided with protection means in accordance with the invention.

Only the third protection device is made sufficiently large to obtain a reverse resistance which is small enough to withstand the discharge current. However, as the third protection device is shared in common by all or at least a number of protected circuit elements connected to several information terminals, the total area required by the entire integrated circuit is hardly not affected by the area needed for the third protection device. Therefore, especially with integrated circuit comprising a large number of information terminals, on the whole chip area is saved by the invention.

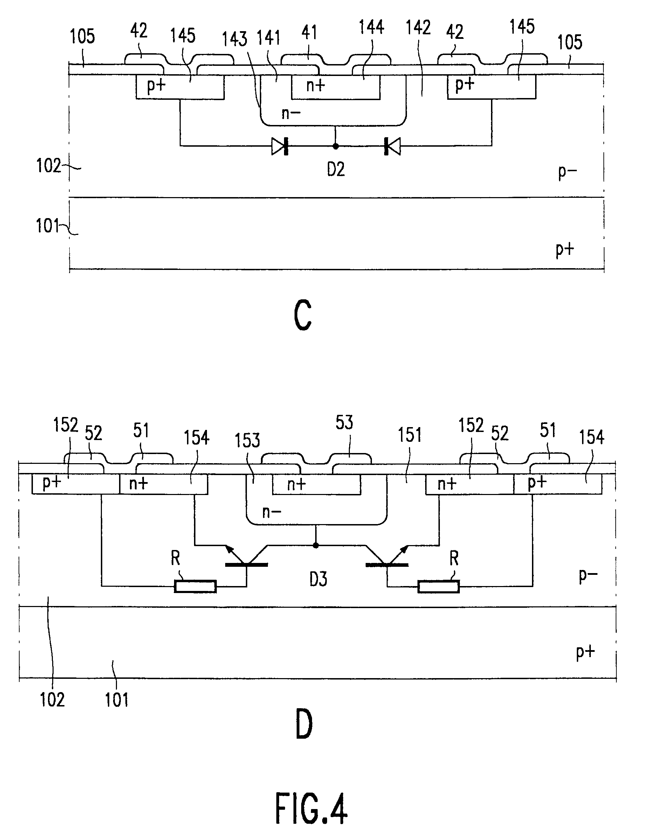

The circuit of figure 1 has been integrated in a semiconductor device, shown in figures 4A-4D. The semiconductor device comprises a p-type semiconductor body 100 of silicon doped with boron, consisting of a relatively heavily doped substrate 101 on which a comparatively weakly doped epitaxial layer 102 is provided by epitaxial growth.

As shown in figure 4A, the p-channel MOS transistor T1 is provided in a relatively weakly n-type semiconductor well 103 which has been created by the local introduction of a suitable n-type dopant, in this case phosphorus, in a sufficient dose to overdope the epitaxial layer 102. The transistor T1 comprises a p-type source region 112 and a p-type drain region 113 which are comparatively heavily doped with boron. The source and drain region 112,113 are separated from each other by a part of the n-well which forms a channel region 114 of the transistor. The channel region is covered by a layer 104 of a suitable gate dielectric, as in this case silicon oxide with a thickness of approximately 200 Å. A gate electrode 11 of n-type polycrystalline silicon is positioned above the channel region 114 on the gate dielectric 104 in order to obtain a controllable current path from the source region 112 to the drain region 113 via the channel region 114.

The n-channel transistor T2 is provided in the epitaxial layer 102 directly and comprises a n-type source region 122 and a n-type drain region 123, which are both comparatively heavily doped with arsenic. The source and drain region 122,123 are similarly separated from each other by a channel region 124 which in this case is formed by a surface adjoining part of the epitaxial layer 102. A gate electrode 21 overlies the channel region 124 and is separated from it by the gate dielectric layer 104 of silicon oxide.

The device is covered with a comparatively thick isolating layer 105 of silicon oxide (TEOS) which has been provided with openings at selected areas through which the source regions 112,122 and drain regions 113,123 of both transistors are contacted by source electrodes 12,22 and drain electrodes 13,23 respectively of aluminium or another proper conducting material such as another metal or a metal composition or compound like a (refractory)metal silicide or a metal alloy. The drain electrodes 13,23 of both transistors are merged in order to provide for the desired drain interconnection. Outside the plane of the drawing, the source electrodes 12,22 are connected to the first and second supply line 4,5 respectively. The gate electrodes 11,21 are similarly connected in common to the input line 6 outside the plane of the drawing.

At the top, the entire body is covered with a suitable passivation layer of phosphosilicate glass (PSG) or borophosphosilicate glass (BPSG) which inter alia helps to planarize the surface of the device but is not shown in the drawings for sake of clarity like other features which are applied to finish and mount the device.

The diode D1 forming the first protection device is shown in figure 4B. It comprises a comparatively heavily doped p-type anode region 132 located in a comparatively weakly doped n-type cathode region 131, which regions have been formed simultaneously with the source and drain region 112,113 respectively the n-well 103 of the p-channel MOS-transistor T1. The anode region 132 and cathode region 131 form together a rectifying PN-junction 133 at the circumference of the anode region 132. In order to facilitate a good electrical contact to the cathode region 131, a comparatively heavily doped n-type contact region 134 has been provided at the surface in the same process step as the formation of the source and drain region 122,123 of the n-channel MOS-transistor T2. At the area of the anode region 132 and of the contact region 134 contact windows are provided in the insulating oxide layer 105 overlying the device in order to accommodate a anode contact 32 and a cathode contact 31 respectively. The contacts 31,32 are formed in the same process step as the source and drain contacts 12,13,22,23 of the MOS-transistors T1,T2. Outside the plane of the drawing, the cathode contact 31 is connected to the first supply line 4 and the anode contact 32 to the information line 6.

The diode D2 forming the second protection device comprises, cf. figure 4C, a relatively lowly doped n-type cathode region 141 which has been formed simultaneously with the n-well of the p-channel transistor T1. A p-type anode region 142 is formed by a part of the p-type epitaxial layer 102 adjoining the cathode region 141. The cathode region 141 and the anode region 142 form a rectifying PN junction 143 with each other along the entire circumference of the cathode region 141. For a proper electrical connection, a relatively heavily doped n-type and p-type contact region 144 and 145 have been provided in the cathode region 141 and anode region 142 respectively which are formed simultaneously with the source and drain regions of respectively the n-channel transistor T2 and the p-channel transistor T1. At the locations of the contact regions 144,145, contact windows are provided in the overlying oxide layer 105 in order to provide for an electrical connection with a cathode electrode 41 and an anode electrode 42 respectively, formed simultaneously with the source and drain electrodes 12,13,22,23 of the transistors T1,T2. The cathode electrode 41 is connected to the information line 6 and the anode electrode 42 to the second supply line 5 outside the plane of the drawing.

Figure 4D shows a lateral NPN bipolar transistor which constitutes the third protection device D3. The device comprises a rather heavily doped n-type emitter region 152 and collector region 153 which are laterally spaced apart by a part of the comparatively weakly doped epitaxial layer 102, which forms a base region 151 of the transistor. The emitter region 152 and the collector region 153 are formed in the same process step as the source and drain region 122,123 of the n-channel MOS-transistor T2. Adjacent the emitter region 152, the base region 151 has been provided with a comparatively heavily doped p-type base contact region 154. This region 154 is formed simultaneously with the source and drain region 112,113 of the p-channel MOS-transistor T1. The oxide layer 105 covering the surface of the semiconductor body 101,102 is provided with contact openings at the location of the collector region 153 and the boundary between the emitter region 152 and the base contact region 154. Via the contact windows a collector electrode 53 and a combined emitter/base electrode 51,52 are provided to the respective regions. The inherent resistance of the part of the epitaxial layer 102 between the emitter/base contact 51,52 and the base region 151 accounts for the required resistance R between the base 51 and the emitter 52 of the transistor D3. Outside the plane of the drawing the collector electrode 53 is connected to the first supply line 4 whereas the common emitter/base electrode 51,52 is coupled to the second supply line 5. The whole structure of the transistor D3 is stretched such that it has a sufficiently small resistance of about 2 Ω when it is stressed in reverse under the influence of a discharge voltage. In this manner the structure of D3 is able to withstand the discharge curtent in both directions. Because of the smaller breakdown voltage of the third protection device as compared to the breakdown voltages of the other two protection devices, which is inter alia due to the relatively high dopant concentration applied for the emitter and collector region 152,153, it is ascertained that only the third protection device might be stressed in reverse. As a consequence the first and second protection device D1,D2 need not be stretched like the third protection device D3 which saves a considerable amount of chip area, especially when a large number of information terminals are involved.

Although the present invention has been described with reference to merely a single embodiment thereof, it will be appreciated that the invention is by no means limited to the embodiment given. For a skilled person are in stead many further variations and modifications possible, without departing from the scope of the present invention.

For example the conductivity types of the different regions may be replaced by the opposite conductivity types and the materials described may be substituted by other suitable materials. Moreover besides in MOS integrated circuits the invention is also very well applicable in circuits of another type like bipolar circuits or circuits comprising bipolar as well as MOS transistors.

Further it is possible to use other kind of protection devices or more protection devices in combination to limit the voltage on the information terminal(s) to a non-destructive level. Moreover an information terminal need not be provided for specifically two circuit components in common. It might as well be provided for a single component or more than two components in common.

Besides for information terminals ion the form of input terminals, the invention is equally well applicable for output terminals or so called I/O terminals which account for bi-directional information transfer.

In general the invention enables the skilled person to save chip area by devising the protection means such that between both supply terminals a protection device is present having a lower breakdown voltage than the protection devices connected to the information terminals to be protected.

## Claims

1. Semiconductor device with an integrated circuit comprising a number of information terminals for transferring information between a number of circuit components and an external environment, in which said circuit components are coupled to a first supply terminal and to a second supply terminal and in which the information terminals are each provided with over voltage protection means, which comprise a first protection device connected between the first supply terminal and the information terminal and a second protection device connected between the information terminal and the second supply terminal, **characterized** in that the protection means moreover comprise a third protection device connected between the first supply terminal and the second supply terminal, in that the third protection device has a smaller reverse breakdown voltage than the first- and second protection device, and in that said information terminals share the third protection device in common.

2. Semiconductor device as claimed in claim 1 **characterized** in that during operation the first supply terminal carries a positive operation voltage with respect to the second supply terminal, in that the first protection device comprises a first diode connected with a cathode region to the first supply terminal and with an anode region to the information terminal, in that the second protection device comprises a second diode connected with a cathode region to the information terminal and with an anode region to the second supply terminal and in that the third protection device comprises a bipolar transistor connected with an emitter region and a collector region to the supply terminals.

3. Semiconductor device as claimed in claim 2 **characterized** in that the integrated circuit comprises several insulated gate field effect transistors with a doped source and drain regions which are separated from one another by a channel region of an opposite conductivity type and in that the third protection device comprises a lateral bipolar transistor of which an emitter region and a collector region have been formed simultaneously with the source and drain region of an insulated gate field effect transistor.

4. Semiconductor device as claimed in claim 2 or 3 **characterized** in that the third protection device comprises a bipolar transistor with an n-type emitter region and collector region separated from one another by a p-type base region, in that the base region has been provided with a comparatively heavily doped base contact region, in that the collector region is coupled to the first supply terminal through a collector electrode and in that the emitter region and the base contact region are provided with a common base/emitter electrode by which they are coupled to the second supply terminal.

5. Semiconductor device as claimed in claim 3 or 4 **characterized** in that at least one of the first and second protection device comprises a diode of which either the anode region or the cathode region is formed simultaneously with the source and drain of a field effect transistor and the other of the anode and cathode region is doped less heavily than the emitter and collector region of the third protection device.

6. Semiconductor device as claimed in claim 3 or 4 **characterized** in that at least one of the first and second protection device comprises an anode region and a cathode region which are doped less heavily than the emitter and collector region of the third protection device.
